# EUROPEAN PATENT SPECIFICATION

(11) **EP 2 581 399 B1**
(45) Date of publication and mention of the grant of the patent: **27.11.2019**
(21) Application number: 10852687.2
(22) Date of filing: 09.06.2010
(51) Int. Cl.: C08G 61/12, C09K 11/06, H01L 51/50

(54) **CONJUGATED POLYMER BASED ON PERYLENE TETRACARBOXYLIC ACID DIIMIDE AND BENZODITHIOPHENE AND ITS PREPARATION METHOD AND APPLICATION**
KONJUGIERTES POLYMER AUF DER BASIS VON PERYLENTETRACARBONSÄURE-DIIMID UND BENZODITHIOPHEN, VERFAHREN ZU SEINER HERSTELLUNG UND ANWENDUNG
POLYMÈRE CONJUGUÉ BASÉ SUR LE PÉRYLÈNE DIIMIDE DE L'ACIDE TÉTRACARBOXYLIQUE ET LE BENZODITHIOPHÈNE, SON PROCÉDÉ DE PRÉPARATION ET SON APPLICATION

(43) Date of publication of application: 17.04.2013
(73) Proprietor: Ocean's King Lighting Science&Technology Co., Ltd., Shenzhen, Guangdong 518054 (CN)
(72) Inventor: ZHOU, Mingjie, Shenzhen Guangdong 518054 (CN); HUANG, Jie, Shenzhen Guangdong 518054 (CN); GUAN, Rong, Shenzhen Guangdong 518054 (CN)
(74) Representative: Michalski Hüttermann & Partner Patentanwälte mbB
(86) International application number: PCT/CN2010/073727
(87) International publication number: WO 2011/153694

(56) References cited:
- EP-A1- 2 006 291
- WO-A1-2009/098250
- WO-A1-2009/098250
- CN-A- 1 599 964
- CN-A- 101 407 574
- CN-A- 101 407 574
- LIJUN HUO ET AL: "Bandgap and Molecular Level Control of the Low-Bandgap Polymers Based on 3,6-Dithiophen-2-yl-2,5-dihydropyrrolo[3,4 -c]pyrrole-1,4-dione toward Highly Efficient Polymer Solar Cells", MACROMOLECULES, AMERICAN CHEMICAL SOCIETY, WASHINGTON, DC; US, vol. 42, no. 17, 1 January 2009 (2009-01-01), pages 6564-6571, XP002550174, ISSN: 0024-9297, DOI: 10.1021/MA9012972 [retrieved on 2009-08-06]
- XIAO S ZHOU H ET AL: "Conjugated Polymers of Fused Bithiophenes with Enhanced pi-Electron Delocalization for Photovoltaic Applications", MACROMOLECULES, AMERICAN CHEMICAL SOCIETY, WASHINGTON, DC; US, vol. 41, no. 15, 12 July 2008 (2008-07-12) , pages 5688-5696, XP002612427, ISSN: 0024-9297, DOI: 10.1021/MA800776Q

## Description

### FIELD OF THE INVENTION

The present invention relates to the optoelectronic field, and particularly relates to a conjugated polymer based on perylene tetracarboxylic acid diimide and dibenzothiophene and the preparation method thereof.

### BACKGROUND OF THE INVENTION

Using cheap materials for preparation of the solar cell having low cost and high efficiency has been the research hotspot and difficulty in the photovoltaic field. The traditional silicon solar cell used for ground has complicated production process and high cost, making its application restricted. In order to reduce the cost and expand the scope of application, people have always been looking for a new solar cell material for a long time.

The polymer solar cell has attracted a lot of attention because of such advantages as low-price raw materials, light weight, being flexible, simple production process, and enabling large-area preparation by coating, printing and other means. It will have a very huge market prospect if its energy conversion efficiency can be improved to near the level of the commercial silicon solar cell. Since N.S. Sariciftci et al. reported in 1992 in the SCIENCE (N.S Sariciftci, L. Smilowitz, A.J. Heeger, et al., Science, 1992, 258, 1474) about the photoinduced electron transfer phenomenon between the conjugated polymer and C60, people have done a great deal of research in the polymer solar cell and obtained rapid development.

CN 101 407 574 A relates to a donor-recipient typed conjugated polymer containing two thiofuran and pyrrole and the preparation method and applications thereof. Using a construction mode of donor-recipient typed co polymerization for preparing the conjugated polymer can absorb action spectrum, cover UV-Visible and near infrared region to fully use sunlight. The donor uses a constitution unit of two thiofuran and pyrrole with a good plane performance, high density of electron cloud and easy preparation. The preparation of the conjugated polymer is easy, with absorbing spectrum in the UV-Visible and near infrared region of 300 to 1000 nm and the energy transforming efficiency being 3 percent.

WO 2009/098250 A1 relates to semiconductor materials prepared from perylene-imide copolymers. Such polymers can exhibit high n-type carrier mobility and/or good current modulation characteristics. In addition, the compounds of the present teachings can possess certain processing advantages such as solution-processability and/or good stability at ambient conditions.

EP 2 006 291 A1 relates to a fused ring compound and a production method thereof, a polymer, an organic thin film including these, and an organic thin film device and organic thin film transistor including this.

Further, benzobithiophene compounds are discussed in LIJUN HUO ET AL: "Bandgap and Molecular Level Control of the Low-Bandgap Polymers Based on 3,6-Dithiophen-2-yl-2,5-dihydropyrrolo[3,4-c]pyrrole-1,4-dione toward Highly Efficient Polymer Solar Cells", MACROMOLECULES, AMERICAN CHEMICAL SOCIETY, WASHINGTON, DC; US, vol. 42, no. 17, 1 January 2009 (2009-01-01), pages 6564-6571; and XIAO S ZHOU H ET AL: "Conjugated Polymers of Fused Bithiophenes with Enhanced pi-Electron Delocalization for Photovoltaic Applications", MACROMOLECULES, AMERICAN CHEMICAL SOCIETY, WASHINGTON, DC; US, vol. 41, no. 15, 12 July 2008 (2008-07-12), pages 5688-5696.

The research of the polymer solar cell is focused mainly on the donor/acceptor blends; the energy conversion efficiency of the PTB7/PC71BM blends has attained 7.4% (Y. Liang et al., Adv. Mater.; DOI:10.1002/adma.200903528), but it is still much lower than that of the inorganic solar cell. There are the following main limiting factors that restrict the performance improvement: The organic semiconductor device has a relatively low carrier mobility, the device has a spectral response not matching with the solar radiation spectrum, the red light region having a high photon flux has not been used effectively, and the carrier has a low electrode collecting efficiency, etc.. In order to make the polymer solar cell get actual application, it is still the priority of the research field to develop new materials and greatly improve the energy conversion efficiency.

### SUMMARY OF THE INVENTION

Accordingly, it is necessary to provide a conjugated polymer based on perylene tetracarboxylic acid diimide and dibenzothiophene that has high photoelectric conversion efficiency.

In addition, it is also necessary to provide a method of preparing the conjugated polymer based on perylene tetracarboxylic acid diimide and dibenzothiophene that has high photoelectric conversion efficiency.

A conjugated polymer based on perylene tetracarboxylic acid diimide and dibenzothiophene is provided, having the following general formula: 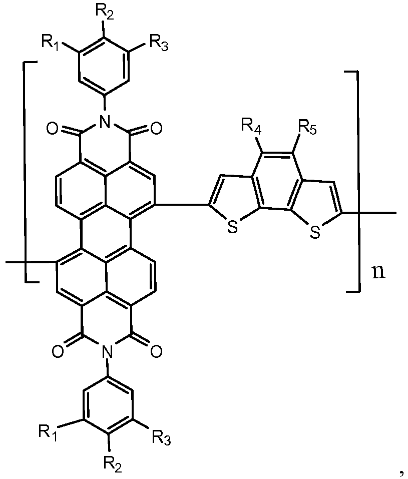 wherein: n is a positive integer less than 101; R₁, R₂ and R₃ are a hydrogen, a C₁-C₂₀ alkyl and a C₁-C₂₀ alkoxy phenyl or phenyl; and R₄ and R₅ are a C₁-C₂₀ alkyl.

A method of preparing the conjugated polymer based on perylene tetracarboxylic acid diimide and dibenzothiophene is provided, comprising the following steps:
S11: perylene tetracarboxylic acid diimide dibromide or its derivatives and an organic tin compound containing a dibenzothiophene unit are mixed and dissolved in an organic solvent at a molar ratio of 1:1 to 1.5:1; and
S12: a catalyst is added to the solution of Step S11 under an anaerobic environment, and a Stille coupling reaction goes on at 50°C to 120°C for 24 to 72 hours, producing a solution of the conjugated polymer, with the reaction equation thereof as follows:

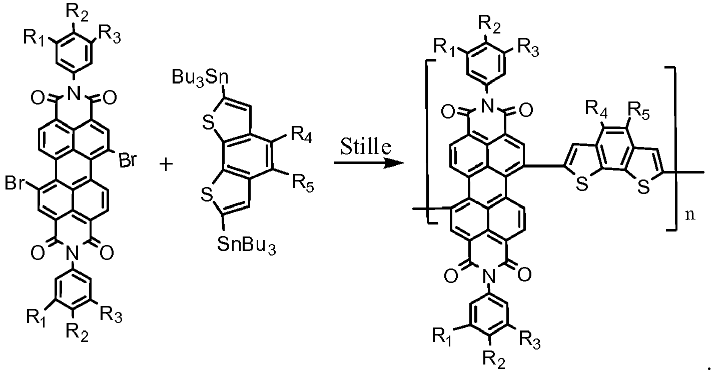

Preferably, the organic solvent in Step S11 is selected from the group consisting of tetrahydrofuran, dimethyl amide, dioxane, ethylene glycol dimethyl ether, benzene, and toluene; the catalyst in Step S12 is added in an amount from 0.01% to 5% by molar number of the total materials; the catalyst is an organic palladium or a mixture of the organic palladium and an organophosphine ligand; the organic palladium is selected from the group consisting of Pd₂(dba)₃, Pd(PPh₃)₄ and Pd(PPh₃)₂Cl₂; the organophosphine ligand is P(o-Tol)₃; and a molar ratio of the organic palladium to the organophosphine ligand in the mixture thereof is from 1:2 to 1:20.

Preferably, the method of preparing the conjugated polymer further includes the purification process after the conjugated polymer solution is obtained, which comprises the following specific steps:
S13: the conjugated polymer solution is added in droplets into methanol for precipitation treatment, and then filtered, washed with methanol, and dried, producing a colloid containing the conjugated polymer; S14: the colloid containing the conjugated polymer is dissolved in toluene, then the toluene solution is added into an aqueous solution of sodium diethyldithiocarbamate, and then the resultant solution goes through an aluminum oxide column chromatography after heat agitation at 80°C to 100°C to isolate the conjugated polymer, and finally decompression is performed after chlorobenzene elution to remove the organic solvent; and S15: Step S13 is repeated at least once, and acetone Soxhlet is used to extract the conjugated polymer isolated in Step S14, producing a solid of the conjugated polymer.

A solar cell device prepared with the above-mentioned conjugated polymer based on perylene tetracarboxylic acid diimide and dibenzothiophene is provided, comprising the following sequentially arranged structures: a substrate, a conductive layer, a poly(3,4-ethylenedioxythiophene)/poly(styrenesulfonate) layer, and a conjugated polymer layer having an active effect and an aluminum metal layer.

A method of manufacturing the above-mentioned solar cell device is provided, comprising the following steps:
S21: the substrate is cleaned, and then a surface thereof is deposited with a conductive layer;
S22: the conductive layer is surface treated and is coated with poly(3,4-ethylenedioxythiophene)/poly(styrenesulfonate) to form a poly(3,4-ethylenedioxythiophene)/poly(styrenesulfonate) layer;
S23: the poly(3,4-ethylenedioxythiophene)/poly(styrenesulfonate) layer is coated with the conjugated polymer to form a conjugated polymer layer having an active effect; and
S24: an aluminum metal layer is formed on the conjugated polymer layer, producing the solar cell device.

An organic electroluminescent device prepared with the above-mentioned conjugated polymer based on perylene tetracarboxylic acid diimide and dibenzothiophene is provided, comprising the following sequentially arranged structures: a substrate, a conductive layer, a conjugated polymer layer having luminescent property, a LiF buffer layer and an aluminum metal layer.

A method of preparing the above-mentioned organic electroluminescent device is provided, comprising the following steps:
S31: the substrate is cleaned, and then one surface of it is coated with a conductive layer;
S32: the conductive layer, after undergoing surface treatment, is coated with the conjugated polymer to form a conjugated polymer layer having a luminous effect;
S33: LiF is coated onto the conjugated polymer layer by vapor deposition, forming a LiF buffer layer; and
S34: an aluminum metal layer is provided on the LiF buffer layer, producing the organic electroluminescent device.

An organic field effect transistor prepared with the above-mentioned conjugated polymer based on perylene tetracarboxylic acid diimide and dibenzothiophene is provided, comprising the following sequentially arranged structures: a doped silicon substrate, a SiO₂ insulating layer, an octadecyltrichlorosilane layer, a conjugated polymer organic semiconductor layer, and metal source and drain electrodes.

A method of preparing the above-mentioned field effect transistor is provided, comprising the following steps:
S41: the doped silicon substrate is cleaned, and coated with the SiO₂ insulating layer having an insulating effect;
S42: the SiO₂ insulate layer is coated with octadecyltrichlorosilane to form an octadecyltrichlorosilane layer;
S43: the octadecyltrichlorosilane layer is coated with the conjugated polymer to form a conjugated polymer organic semiconductor layer; and
S44: the metal source and drain electrodes are provided on the conjugated polymer organic semiconductor layer, producing the organic field effect transistor.

Perylene tetracarboxylic acid diimide and its derivatives, having a large co-benzene-ring planar structure and a two-imine-ring structure, have strong absorption in the visible light region, high light, heat and environmental stability, and high electron affinity (low LUMO level), as well as high electron mobility along the stacking direction because of the π-π stacking between their big conjugated π bonds. Therefore, it has shown broad application prospects in a variety of fields such as the organic solar cell.

The conjugated polymer, through introduction of a substituent at the site of "bay" of perylene tetracarboxylic acid diimide and copolymerization of the perylene tetracarboxylic acid diimide monomer with other monomers, makes solubility of perylene tetracarboxylic acid diimide increased. Besides, the dibenzothiophene unit is a unit having a good planar structure and containing a backbone composed of two five-membered rings and one six-membered ring and, because of its good flatness and conjugated degree, it has very high mobility, and makes its solubility and soluble processing property improved by such modifications as introduction of an alkyl into the sites 4 and 5 on the dibenzothiophene unit. Therefore, the dibenzothiophene unit is copolymerized with perylene tetracarboxylic acid diimide to form an electron donor-acceptor structure to get the band gap of the polymer adjusted, and to push its absorption band edge toward the infrared and near infrared region to achieve higher photoelectric conversion efficiency.

This method of preparing the conjugated polymer is simple and feasible, and has a low requirement for facilities, and possesses strong practicability.

### BRIEF DESCRIPTION OF THE DRAWINGS

FIG. 1 is a structural schematic view of an embodiment of the solar cell device.
FIG. 2 is a structural schematic view of an embodiment of the organic electroluminescence device.
FIG. 3 is a structural schematic view of an embodiment of the organic field effect transistor.

### DETAILED DESCRIPTION

A purpose of the present invention is to provide a conjugated polymer based on perylene tetracarboxylic acid diimide and dibenzothiophene, which has good solubility, wide optical absorption spectrum, and high photoelectric conversion efficiency. The present invention further provides a method of preparing the conjugated polymer, and indicates application of this conjugated polymer in the optoelectronic field.

A conjugated polymer based on perylene tetracarboxylic acid diimide and dibenzothiophene is provided, having the following general formula: 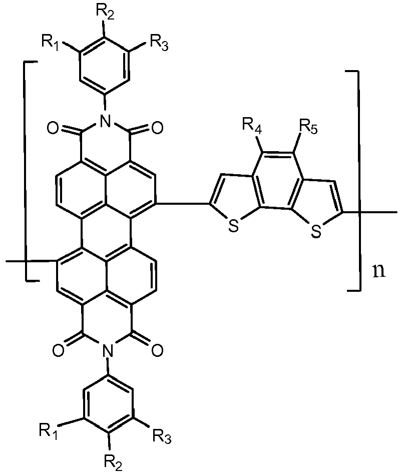 wherein: n is a positive integer less than 101; R₁, R₂ and R₃ are a hydrogen, a C₁-C₂₀ alkyl and a C₁-C₂₀ alkoxy phenyl or phenyl; and R4 and R5 are a C₁-C₂₀ alkyl.

A method of preparing the conjugated polymer based on perylene tetracarboxylic acid diimide and dibenzothiophene is provided, comprising the following steps:
S11: perylene tetracarboxylic acid diimide dibromide or its derivatives and an organic tin compound containing a dibenzothiophene unit are mixed and dissolved in an organic solvent at a molar ratio of 1:1 to 1.5:1.
S12: a catalyst is added to the solution of Step S11 under an anaerobic environment, and a Stille coupling reaction is performed at 50°C to 120°C for 24 to 72 hours to produce a solution of the conjugated polymer, with a reaction equation thereof as follows:

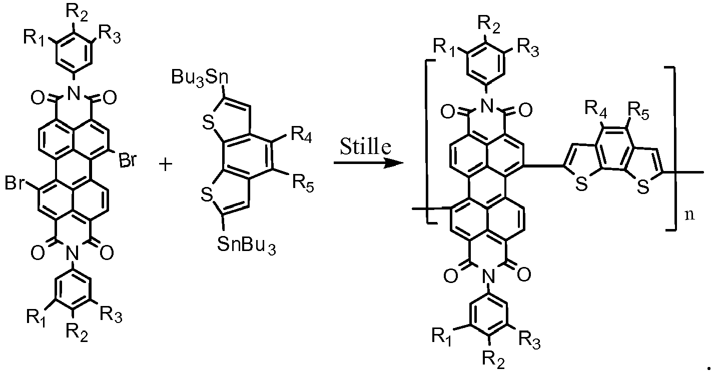

Preferably, the organic solvent in Step S11 is selected from the group consisting of tetrahydrofuran, dimethyl amide, dioxane, ethylene glycol dimethyl ether, benzene and toluene; the anaerobic environment in Step S12 is composed of nitrogen or inert gases; the catalyst is added in an amount from 0.01% to 5% by molar number of the total materials; the catalyst is an organic palladium or a mixture of the organic palladium and an organophosphine ligand; the organic palladium is selected from the group consisting of Pd₂(dba)₃, Pd(PPh₃)₄ and Pd(PPh₃)₂Cl₂; the organophosphine ligand is P(o-Tol)₃; and a molar ratio of the organic palladium to the organophosphine ligand in the mixture thereof is from 1:2 to 1:20.

Preferably, the method of preparing the conjugated polymer further includes the purification process after the conjugated polymer solution is obtained, which comprises the following specific steps:
S13: the conjugated polymer solution is added in droplets into methanol for precipitation treatment, and then filtered, washed with methanol, and dried, producing a colloid containing the conjugated polymer; S14: the colloid containing the conjugated polymer is dissolved in toluene, then the toluene solution is added into an aqueous solution of sodium diethyldithiocarbamate, and then the resultant solution goes through an aluminum oxide column chromatography after heat agitation at 80°C to 100°C to isolate the conjugated polymer, and finally decompression is performed after chlorobenzene elution to remove the organic solvent; and S15: Step S13 is repeated at least once, and acetone Soxhlet is used to extract the conjugated polymer isolated in Step S14, producing a solid of the conjugated polymer.

This method of preparing the conjugated polymer is simple and feasible, has a low requirement for facilities, and possesses strong practicability.

The conjugated polymer has the widespread application prospect in the photoelectric field, such as the solar cell device, the organic electroluminescent device and the organic field effect transistor.

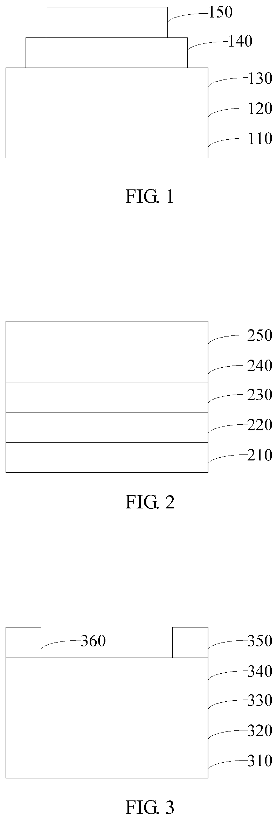

A solar cell device as shown in Fig. 1 comprises the following sequentially arranged structures: a substrate 110, a conductive layer 120, a poly(3,4-ethylenedioxythiophene)/poly(styrenesulfonate) layer 130, a conjugated polymer layer 140 having an active effect and prepared with the above conjugated polymer, and an aluminum metal layer 150.

A method of manufacturing the above-mentioned solar cell device is provided, comprising the following steps:
S21: the substrate is cleaned, and then one surface of it is deposited with a conductive layer;
S22: the conductive layer is surface treated and then coated with poly(3,4-ethylenedioxythiophene)/poly(styrenesulfonate) to form a poly(3,4-ethylenedioxythiophene)/poly(styrenesulfonate) layer;
S23: the poly(3,4-ethylenedioxythiophene)/poly(styrenesulfonate) layer is coated with the conjugated polymer to form a conjugated polymer layer having an active effect; and
S24: an aluminum metal layer is provided on the conjugated polymer layer to produce the solar cell device.

In a preferred embodiment, an ITO glass (indium-tin oxide glass) is used as the base of the substrate, glass is used as the substrate, the indium-tin oxide having a square resistance of 10-20 Ω/sq is used as the conductive layer, an oxygen-plasma treatment is adopted in the surface treatment process in Step S22, and the conjugated polymer is coated onto the poly(3,4-ethylenedioxythiophene)/poly(styrenesulfonate) layer by the spincoating technique.

An organic electroluminescent device as shown in FIG. 2 comprises the following sequentially arranged structures: a substrate 210, a conductive layer 220, a conjugated polymer layer 230 having luminescent property and prepared with the above conjugated polymer, a LiF buffer layer 240, and an aluminum metal layer 250.

A method of preparing the above-mentioned organic electroluminescent device is provided, comprising the following steps:
S31: the substrate is cleaned, and then one surface of it is deposited with a conductive layer;
S32: the conductive layer is surface treated and coated with the conjugated polymer to form a conjugated polymer layer having a luminous effect;
S33: LiF is coated onto the conjugated polymer layer by vapor deposition, forming a LiF buffer layer; and
S34: an aluminum metal layer is formed on the LiF buffer layer to produce the organic electroluminescent device.

In a preferred embodiment, an ITO glass (indium-tin oxide glass) is used as the base of the substrate, glass is used as the substrate, the indium-tin oxide having a square resistance of 10-20 Ω/sq is used as the conductive layer, an oxygen-plasma treatment is adopted in the surface treatment process in Step S22, and the conjugated polymer is coated onto the poly(3,4-ethylenedioxythiophene)/poly(styrenesulfonate) layer by the spincoating technique.

An organic field effect transistor as shown in FIG. 3 comprises the following sequentially arranged structures from bottom to top: a doped silicon substrate 310, a SiO₂ insulating layer 320, an octadecyltrichlorosilane layer 330, a conjugated polymer organic semiconductor layer 340 prepared with the above conjugated polymer, and a metal source electrode 350 and a metal drain electrode 360.

A method of preparing the above-mentioned field effect transistor is provided, comprising the following steps:
S41: the doped silicon substrate is cleaned, and deposited with the SiO₂ insulating layer having an insulating effect;
S42: the SiO₂ insulate layer is coated with octadecyltrichlorosilane to form an octadecyltrichlorosilane layer;
S43: the octadecyltrichlorosilane layer is coated with the conjugated polymer to form a conjugated polymer organic semiconductor layer; and
S44: the metal source and drain electrodes are provided on the conjugated polymer organic semiconductor layer, producing the organic field effect transistor.

In a preferred embodiment, a highly-doped silicon wafer is used as the doped silicon substrate, the SiO₂ insulating layer has a thickness of 500 nm, the conjugated polymer is coated onto the octadecyltrichlorosilane layer by the spincoating technique, and the source and drain electrodes are made of gold.

The conjugated polymer of the present invention and the preparation method thereof will further be described below mainly with reference to the specific examples.

### Example 1

### Preparation of poly(N,N'-di-(3,4,5-tri-methyl phenyl)-3,4,9,10-perylene tetracarboxylic acid diimide-(4,5-dihexyl)benzo[2,1-b:3,4-b']dithiophene)

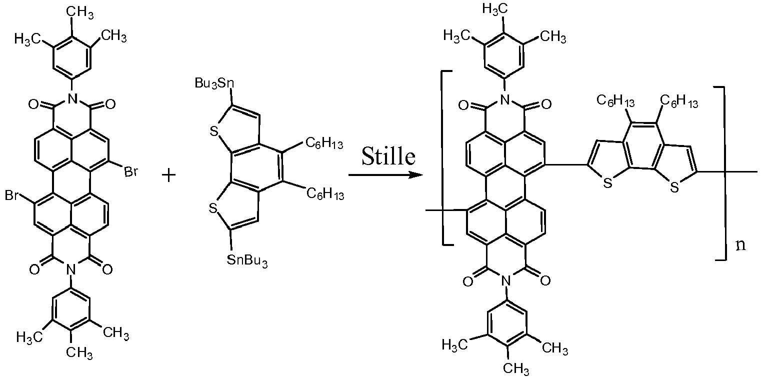

Under the protection of nitrogen, the DMF (18 mL) solution containing 0.5 mmol N,N'-di-(3,4,5-tri-methyl benzene)-1,7-dibromo-3,4,9,10-perylene tetracarboxylic acid diimide and 0.5 mmol 2,7-ditributyltin-(4,5-di-hexyl)benzo[2,1-b:3,4-b']dithiophene was bubbled for 0.5 h to remove oxygen, then Pd₂(dba)₃ (0.14 g, 0.015 mol) and P(o-Tol)₃ (0.0083 g, 0.027 mmol) were added, and then the solution was bubbled for 0.5 h to remove the residual oxygen and then heated to 80°C to react for 48 hours, producing a solution of the conjugated polymer. The conjugated polymer solution was added in droplets into methanol for precipitation treatment, and then filtered and dried, producing a colloid containing the conjugated polymer. The colloid containing the conjugated polymer was dissolved in toluene, then the toluene solution was added into an aqueous solution of sodium diethyldithiocarbamate, and then the resultant solution went through an aluminum oxide column chromatography after heat agitation at 90°C to isolate the conjugated polymer, and finally decompression was performed after chlorobenzene elution to remove the organic solvent. The isolated conjugated polymer was added into methanol for precipitation treatment, and then was filtered, and washed with methanol, and acetone Soxhlet was used to extract the conjugated polymer after the drying treatment, producing a solid of the conjugated polymer. Molecular weight (GPC, THF, R. I): Mn = 24,300, Mw/Mn = 2.66.

### Example 2

### Preparation of poly(N,N'-di-(3,4,5-tri-methoxyphenyl)-3,4,9,10-perylene tetracarboxylic acid diimide-(4-hexyl-5-decyl)benzo[2,1-b:3,4-b']dithiophene)

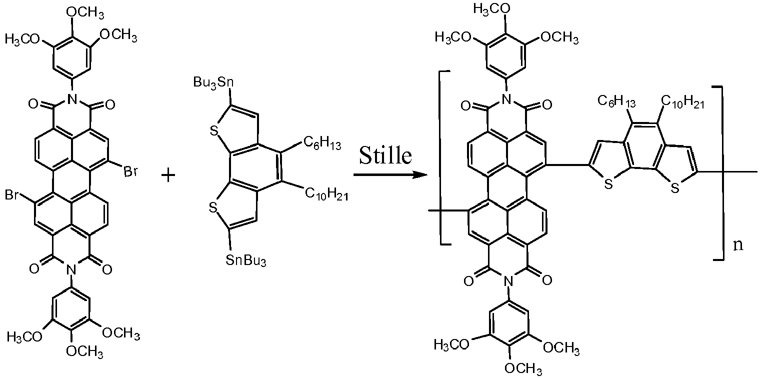

Under the protection of nitrogen, the dioxane (15 mL) solution containing 0.5 mmol N,N'-di-(3,4,5-tri-methoxyphenyl)-1,7-dibromo-3,4,9,10-perylene tetracarboxylic acid diimide and 0.5 mmol 2,7-ditributyltin-(4-hexyl-5-decyl)benzo[2,1-b:3,4-b']dithiophene was bubbled for 0.5 h to remove oxygen, then 10 mg Pd(PPh₃)₂Cl₂ was added, and then the solution was bubbled for 0.5 h to remove the residual oxygen and then heated to 85°C to react for 36 hours, producing a solution of the conjugated polymer. The conjugated polymer solution was added in droplets into methanol for precipitation treatment, and then filtered and dried, producing a colloid containing the conjugated polymer. The colloid containing the conjugated polymer was dissolved in toluene, then the toluene solution was added into an aqueous solution of sodium diethyldithiocarbamate, and then the resultant solution went through an aluminum oxide column chromatography after heat agitation at 90°C to isolate the conjugated polymer, and finally decompression was performed after chlorobenzene elution to remove the organic solvent. The isolated conjugated polymer was added into methanol for precipitation treatment, and then was filtered, and washed with methanol, and acetone Soxhlet was used to extract the conjugated polymer after the drying treatment, producing a solid of the conjugated polymer. Molecular weight (GPC, THF, R. I): Mn = 24,200, Mw/Mn = 2.57.

### Example 3

### Preparation of poly(N,N'-di-(3,4,5-tri-octyloxy phenyl)-3,4,9,10-perylene tetracarboxylic acid diimide-(4,5-di-eicosyl)benzo[2,1-b:3,4-b']dithiophene)

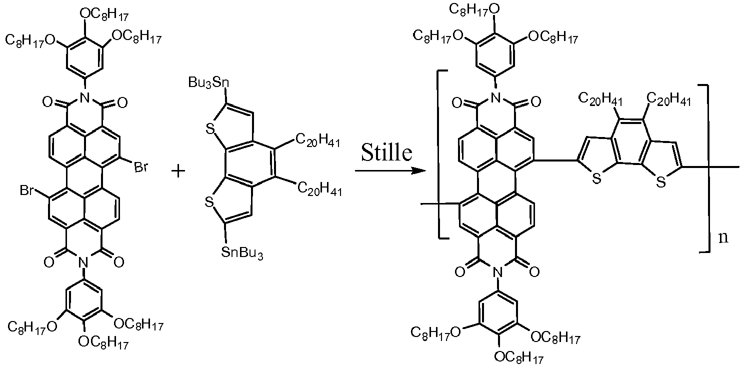

Under the protection of nitrogen, the toluene/THF (30 ml) solution containing 0.5 mmol N,N'-di-(3,4,5-tri-octyloxy phenyl)-1,7-dibromo-3,4,9,10-perylene tetracarboxylic acid diimide and 0.5 mmol 2,7-ditributyltin-(4,5-di-eicosyl)benzo[2,1-b:3,4-b']dithiophene was bubbled for 0.5 h to remove oxygen, then 8 mg Pd(PPh₃)₄ was added, and then the solution was bubbled for 0.5 h to remove the residual oxygen and then heated to 80°C to react for 72 hours, producing a solution of the conjugated polymer. The conjugated polymer solution was added in droplets into methanol for precipitation treatment, and then filtered and dried, producing a colloid containing the conjugated polymer. The colloid containing the conjugated polymer was dissolved in toluene, then the toluene solution was added into an aqueous solution of sodium diethyldithiocarbamate, and then the resultant solution went through an aluminum oxide column chromatography after heat agitation at 80°C to isolate the conjugated polymer, and finally decompression was performed after chlorobenzene elution to remove the organic solvent. The isolated conjugated polymer was added into methanol for precipitation treatment, and then was filtered, and washed with methanol, and acetone Soxhlet was used to extract the conjugated polymer after the drying treatment, producing a solid of the conjugated polymer. Molecular weight (GPC, THF, R. I): Mn = 22,000, Mw/Mn = 2.65.

### Example 4

### Preparation of poly(N,N'-di-(3,5-di-eicosoxyl-4-methyl phenyl)-3,4,9,10-perylene tetracarboxylic acid diimide-(4,5-di-dodecyloxy)benzo[2,1-b:3,4-b']dithiophene)

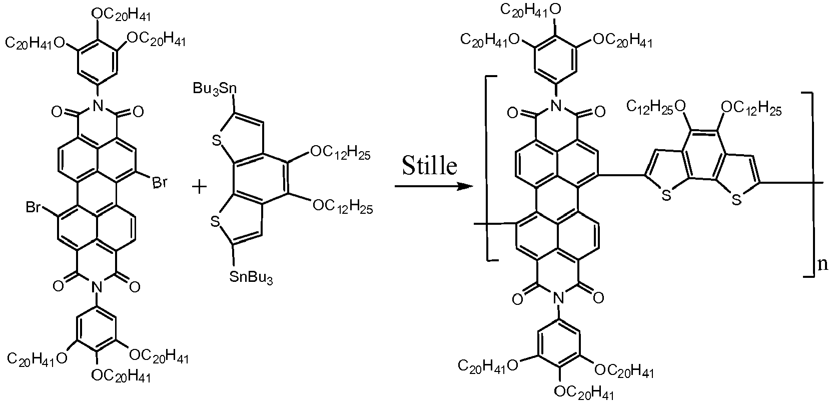

Under the protection of nitrogen, the benzene (20 mL) solution containing 0.52 mmol N,N'-di-(3,5-di-eicasoxyl-4-methyl phenyl)-1,7-dibromo-3,4,9,10-perylene tetracarboxylic acid diimide and 0.5 mmol 2,7-ditributyltin-(4, 5-di-dodecyloxy)benzo[2,1-b:3,4-b']dithiophene was bubbled for 0.5 h to remove oxygen, then 5 mg Pd(PPh₃)₂Cl₂ was added, and then the solution was bubbled for 0.5 h to remove the residual oxygen and then heated to 100°C to react for 56 hours, producing a solution of the conjugated polymer. The conjugated polymer solution was added in droplets into methanol for precipitation treatment, and then filtered and dried, producing a colloid containing the conjugated polymer. The colloid containing the conjugated polymer was dissolved in toluene, then the toluene solution was added into an aqueous solution of sodium diethyldithiocarbamate, and then the resultant solution went through an aluminum oxide column chromatography after heat agitation at 80°C to isolate the conjugated polymer, and finally decompression was performed after chlorobenzene elution to remove the organic solvent. The isolated conjugated polymer was added into methanol for precipitation treatment, and then was filtered, and washed with methanol, and acetone Soxhlet was used to extract the conjugated polymer after the drying treatment, producing a solid of the conjugated polymer. Molecular weight (GPC, THF, R. I): Mn = 25,600, Mw/Mn = 3.76.

### Example 5

### Preparation of poly(N,N'-di-(3,5-di-eicosoxylphenyl)-3,4,9,10-perylene tetracarboxylic acid diimide-(4-methyl-5-methoxyl)benzo[2,1-b:3,4-b']dithiophene)

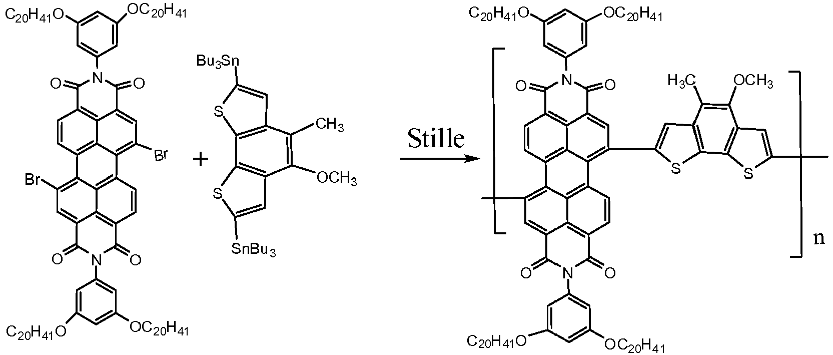

Under the protection of nitrogen, the toluene/DMF (25 ml) solution containing 0.51 mmol N,N'-di-(3,5-di-eicosoxylphenyl)-1,7-dibromo-3,4,9,10-perylene tetracarboxylic acid diimide and 0.5 mmol 2,7-ditributyltin-(4-methyl-5-methoxyl)benzo[2,1-b:3,4-b']dithiophene was bubbled for 0.5 h to remove oxygen, then 10 mg Pd(PPh3)4 was added, and then the solution was bubbled for 0.5 h to remove the residual oxygen and then heated to 70°C to react for 40 hours, producing a solution of the conjugated polymer. The conjugated polymer solution was added in droplets into methanol for precipitation treatment, and then filtered and dried, producing a colloid containing the conjugated polymer. The colloid containing the conjugated polymer was dissolved in toluene, then the toluene solution was added into an aqueous solution of sodium diethyldithiocarbamate, and then the resultant solution went through an aluminum oxide column chromatography after heat agitation at 80°C to isolate the conjugated polymer, and finally decompression was performed after chlorobenzene elution to remove the organic solvent. The isolated conjugated polymer was added into methanol for precipitation treatment, and then was filtered, and washed with methanol, and acetone Soxhlet was used to extract the conjugated polymer after the drying treatment, producing a solid of the conjugated polymer. Molecular weight (GPC, THF, R. I): Mn = 23,300, Mw/Mn = 2.44.

### Example 6

### Preparation of poly(N,N'-di-(3,4,5-tri-phenylphenyl)-3,4,9,10-perylene tetracarboxylic acid diimide-(4,4-di-eicosoxyl)benzo[2,1-b:3,4-b']dithiophene)

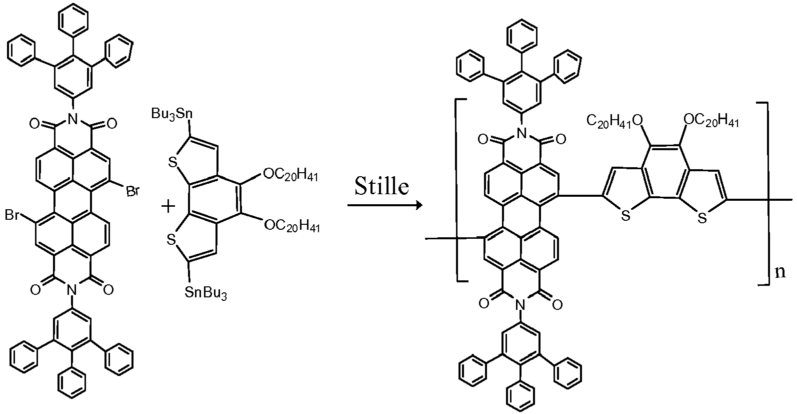

Under the protection of argon, the dioxane/THF (18 ml) solution containing 0.75 mmol N,N'-di-(3,4,5-tri-phenylphenyl)-1,7-dibromo-3,4,9,10-perylene tetracarboxylic acid diimide and 0.5 mmol 2,7-ditributyltin-(4,5-di-eicosoxyl)benzo[2,1-b:3,4-b']dithiophene was bubbled for 0.5 h to remove oxygen, then 8 mg Pd(PPh₃)₂Cl₂ was added, and then the solution was bubbled for 0.5 h to remove the residual oxygen and then heated to 65°C to react for 72 hours, producing a solution of the conjugated polymer. The conjugated polymer solution was added in droplets into methanol for precipitation treatment, and then filtered and dried, producing a colloid containing the conjugated polymer. The colloid containing the conjugated polymer was dissolved in toluene, then the toluene solution was added into an aqueous solution of sodium diethyldithiocarbamate, and then the resultant solution went through an aluminum oxide column chromatography after heat agitation at 90°C to isolate the conjugated polymer, and finally decompression was performed after chlorobenzene elution to remove the organic solvent. The isolated conjugated polymer was added into methanol for precipitation treatment, and then was filtered, and washed with methanol, and acetone Soxhlet was used to extract the conjugated polymer after the drying treatment, producing a solid of the conjugated polymer. Molecular weight (GPC, THF, R. I): Mn = 28,900, Mw/Mn = 2.37.

## Claims

1. A conjugated polymer based on perylene tetracarboxylic acid diimide and dibenzothiophene, having the following general formula: 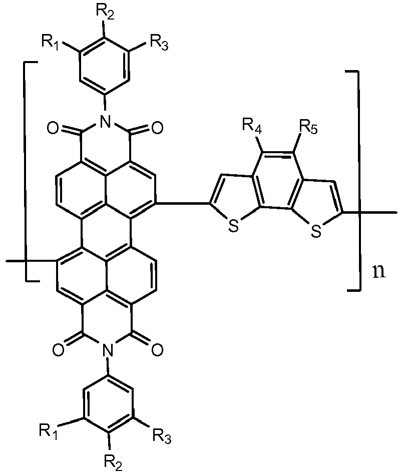
wherein: n is a positive integer less than 101;
R₁, R₂ and R₃ are a hydrogen, a C₁-C₂₀ alkyl and a C₁-C₂₀ alkoxy phenyl or phenyl; and
R₄ and R₅ are a C₁-C₂₀ alkyl.

2. A method of preparing the conjugated polymer based on perylene tetracarboxylic acid diimide and dibenzothiophene, comprising the following steps:
S11: mixing and dissolving perylene tetracarboxylic acid diimide dibromide or its derivatives and an organic tin compound containing a dibenzothiophene unit in an organic solvent at a molar ratio of 1:1 to 1.5:1; and
S12: adding a catalyst to the solution of Step S11 under an anaerobic environment, and performing a Stille coupling reaction at 50°C to 120°C for 24 to 72 hours to produce a solution of the conjugated polymer, with a reaction equation thereof as follows:

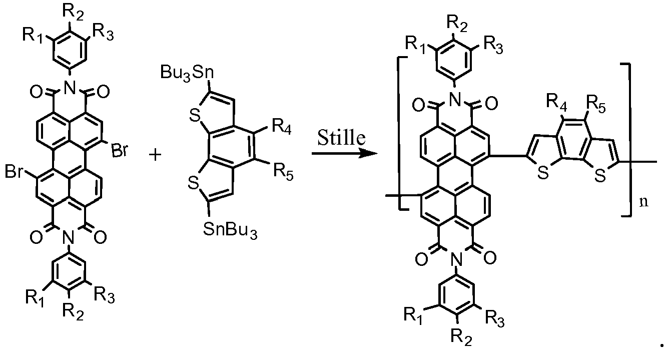

3. The method of preparing the conjugated polymer according to claim 2, wherein the organic solvent in Step S11 is selected from the group consisting of tetrahydrofuran, dimethyl amide, dioxane, ethylene glycol dimethyl ether, benzene, and toluene.

4. The method of preparing the conjugated polymer according to claim 2, wherein the catalyst in Step S12 is added in an amount from 0.01% to 5% by molar number of the total materials;
the catalyst is an organic palladium or a mixture of the organic palladium and an organophosphine ligand;
the organic palladium is selected from the group consisting of Pd₂(dba)₃, Pd(PPh₃)₄ and Pd(PPh₃)₂Cl₂;
the organophosphine ligand is P(o-Tol)₃; and
a molar ratio of the organic palladium to the organophosphine ligand is from 1:2 to 1:20 in the mixture of the organic palladium and the organophosphine ligand.

5. The method of preparing the conjugated polymer according to claim 2, further comprising a purification process after the conjugated polymer solution is obtained, the purification process comprising the following specific steps:
S13: adding the conjugated polymer solution in droplets into methanol for precipitation treatment, and then filtered, washed with methanol and dried, producing a colloid containing the conjugated polymer;
S14: dissolving the colloid containing the conjugated polymer in toluene, then adding the toluene solution into an aqueous solution of sodium diethyldithiocarbamate, and then the resultant solution goes through an aluminum oxide column chromatography after heat agitation at 80°C to 100°C to isolate the conjugated polymer, and finally decompression is performed after chlorobenzene elution to remove the organic solvent; and
S15: repeating Step S13 at least once, and using acetone Soxhlet to extract the conjugated polymer isolated in Step S14 to produce a solid conjugated polymer.

6. A solar cell device prepared with the conjugated polymer according to claim 1, comprising the following sequentially arranged structures: a substrate, a conductive layer, a poly(3,4-ethylenedioxythiophene)/poly(styrenesulfonate) layer, and a conjugated polymer layer having an active effect and an aluminum metal layer.

7. A method of manufacturing the solar cell device according to claim 6, comprising the following steps:
S21: cleaning the substrate, and then depositing a conductive layer on a surface thereof;
S22: surface treating the conductive layer and coating the conductive layer with poly(3,4-ethylenedioxythiophene)/poly(styrenesulfonate) to form a poly(3,4-ethylenedioxythiophene)/poly(styrenesulfonate) layer;
S23: coating the poly(3,4-ethylenedioxythiophene)/poly(styrenesulfonate) layer with the conjugated polymer to form a conjugated polymer layer having an active effect; and
S24: forming an aluminum metal layer on the conjugated polymer layer to produce the solar cell device.

8. An organic electroluminescent device prepared with the conjugated polymer according to claim 1, comprising the following sequentially arranged structures: a substrate, a conductive layer, a conjugated polymer layer having luminescent property, a LiF buffer layer, and an aluminum metal layer.

9. A method of manufacturing the organic electroluminescent device according to claim 8, comprising the following steps:
S31: cleaning the substrate, and then depositing a conductive layer on a surface of the substrate;
S32: surface treating the conductive layer and coating the conductive layer with the conjugated polymer to form a conjugated polymer layer having a luminous effect;
S33: coating LiF onto the conjugated polymer layer by vapor deposition, forming a LiF buffer layer; and
S34: forming an aluminum metal layer on the LiF buffer layer to produce the organic electroluminescent device.

10. An organic field effect transistor prepared with the conjugated polymer according to claim 1, comprising the following sequentially arranged structures: a doped silicon substrate, a SiO₂ insulating layer, an octadecyltrichlorosilane layer, a conjugated polymer organic semiconductor layer, and metal source and drain electrodes.

11. A method of manufacturing the organic field effect transistor according to claim 10, comprising the following steps:
S41: cleaning the doped silicon substrate, and depositing a SiO₂ insulating layer having an insulating effect;
S42: coating the SiO₂ insulate layer with octadecyltrichlorosilane to form an octadecyltrichlorosilane layer;
S43: coating the octadecyltrichlorosilane layer with the conjugated polymer to form a conjugated polymer organic semiconductor layer; and
S44: forming a metal source and a drain electrode on the conjugated polymer organic semiconductor layer to produce the organic field effect transistor.

## Patentansprüche

1. Konjugiertes Polymer auf Basis von Perylentetracarbonsäurediimid und Dibenzothiophen, welches die folgende allgemeine Formel aufweist: 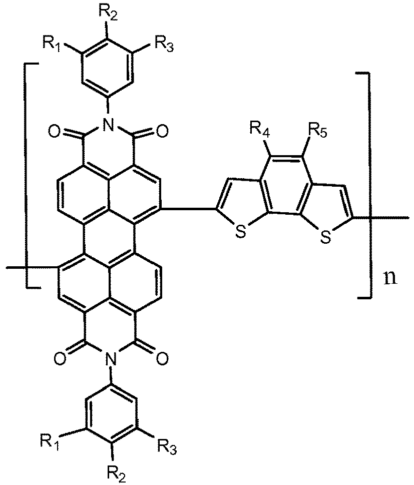
wobei: n eine positive Ganzzahl kleiner als 101 ist,
R₁, R₂ und R₃ ein Wasserstoff, ein C₁-C₂₀-Alkyl und ein C₁-C₂₀-Alkoxyphenyl oder -phenyl sind, und
R₄ und R₅ ein C₁-C₂₀-Alkyl sind.

2. Verfahren zum Herstellen des konjugierten Polymers auf Basis von Perylentetracarbonsäurediimid und Dibenzothiophen, umfassend die folgenden Schritte:
S11: Mischen und Lösen von Perylentetracarbonsäurediimid-Dibromid oder dessen Derivaten und einer eine Dibenzothiophen-Einheit enthaltenden organischen Zinnverbindung in einem organischen Lösungsmittel in einem Molverhältnis von 1:1 bis 1,5:1 und
S12: Zugeben eines Katalysators zu der Lösung aus Schritt S11 in einer anaeroben Umgebung und Durchführen einer Stille-Kupplungsreaktion bei 50 °C bis 120 °C für 24 bis 72 Stunden, um eine Lösung des konjugierten Polymers zu produzieren, wobei eine zugehörige Reaktionsgleichung lautet wie folgt:

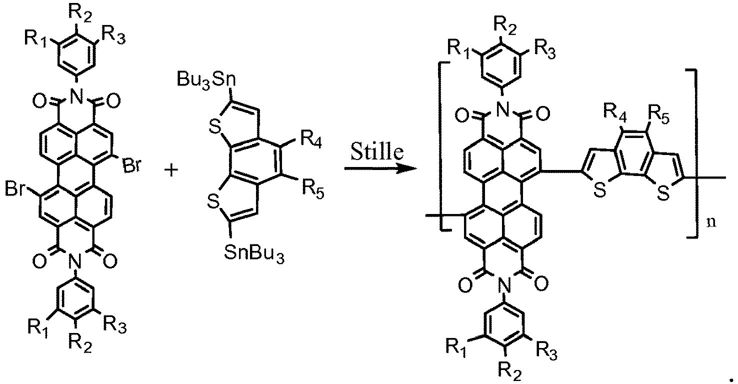

3. Verfahren zum Herstellen des konjugierten Polymers nach Anspruch 2, wobei das organische Lösungsmittel in Schritt S11 ausgewählt wird aus der Gruppe, bestehend aus Tetrahydrofuran, Dimethylamid, Dioxan, Ethylenglykoldimethylether, Benzol und Toluol.

4. Verfahren zum Herstellen des konjugierten Polymers nach Anspruch 2, wobei der Katalysator in Schritt S12 in einer Menge von 0,01 % bis 5 % nach Molzahl der Gesamtmaterialien zugegeben wird,
es sich bei dem Katalysator um ein organisches Palladium oder eine Mischung aus dem organischen Palladium und einem Organophosphinliganden handelt,
das organische Palladium ausgewählt wird aus der Gruppe, bestehend aus Pd₂(dba)₃, Pd(PPh₃)₄ und Pd(PPh₃)₂Cl₂,
es sich bei dem Organophosphinliganden um P(o-Tol)₃ handelt und
ein Molverhältnis des organischen Palladiums zu dem Organophosphinliganden in der Mischung aus dem organischen Palladium und dem Organophosphinliganden von 1:2 bis 1:20 beträgt.

5. Verfahren zum Herstellen des konjugierten Polymers nach Anspruch 2, ferner umfassend einen Reinigungsprozess nachdem die konjugierte Polymerlösung erhalten wurde, wobei der Reinigungsprozess die folgenden konkreten Schritte umfasst:
S13: Zugeben der konjugierten Polymerlösung in Tröpfchen in Methanol zur Ausfällung und anschließendes Filtern, Waschen mit Methanol und Trocknen, wodurch ein das konjugierte Polymer enthaltendes Kolloid produziert wird,
S14: Lösen des das konjugierte Polymer enthaltenden Kolloids in Toluol, anschließendes Zugeben der Toluollösung in eine wässrige Lösung von Natriumdiethyldithiocarbamat, wobei anschließend die resultierende Lösung nach Hitzeverrühren bei 80 °C bis 100 °C zum Isolieren des konjugierten Polymers eine Aluminiumoxid-Säulenchromatografie durchläuft und schließlich nach einer Chlorbenzolelution zum Entfernen des organischen Lösungsmittels eine Dekompression durchgeführt wird, und
S15: mindestens einmaliges Wiederholen des Schritts S13 und Verwenden eines Aceton-Soxhlets, um das in Schritt S14 isolierte konjugierte Polymer zu extrahieren, um ein festes konjugiertes Polymer zu produzieren.

6. Solarzelleneinrichtung, die mit dem konjugierten Polymer nach Anspruch 1 hergestellt ist, umfassend die folgenden aufeinanderfolgend angeordneten Strukturen:
ein Substrat, eine leitfähige Schicht, eine Poly(3,4-ethylendioxythiophen)/Poly(styrolsulfonat)-Schicht und eine konjugierte Polymerschicht mit einer aktiven Wirkung und eine Aluminiummetallschicht.

7. Verfahren zum Herstellen der Solarzelleneinrichtung nach Anspruch 6, umfassend die folgenden Schritte:
S21: Reinigen des Substrats und anschließend Abscheiden einer leitfähigen Schicht auf einer Oberfläche davon,
S22: Vornehmen einer Oberflächenbehandlung der leitfähigen Schicht und Beschichten der leitfähigen Schicht mit Poly(3,4-ethylendioxythiophen)/Poly(styrolsulfonat), um eine Poly(3,4-ethylendioxythiophen)/Poly(styrolsulfonat)-Schicht zu bilden,
S23: Beschichten der Poly(3,4-ethylendioxythiophen)/Poly(styrolsulfonat)-Schicht mit dem konjugierten Polymer, um eine eine aktive Wirkung aufweisende konjugierte Polymerschicht zu bilden, und
S24: Bilden einer Aluminiummetallschicht auf der konjugierten Polymerschicht, um die Solarzelleneinrichtung zu produzieren.

8. Organische elektrolumineszente Einrichtung, die mit dem konjugierten Polymer nach Anspruch 1 hergestellt ist, umfassend die folgenden aufeinanderfolgend angeordneten Strukturen: ein Substrat, eine leitfähige Schicht, eine konjugierte Polymerschicht mit Lumineszenzeigenschaft, eine LiF-Pufferschicht und eine Aluminiummetallschicht.

9. Verfahren zum Herstellen der organischen elektrolumineszenten Einrichtung nach Anspruch 8, umfassend die folgenden Schritte:
S31: Reinigen des Substrats und anschließend Abscheiden einer leitfähigen Schicht auf einer Oberfläche des Substrats,
S32: Vornehmen einer Oberflächenbehandlung der leitfähigen Schicht und Beschichten der leitfähigen Schicht mit dem konjugierten Polymer, um eine eine Leuchtwirkung aufweisende konjugierte Polymerschicht zu bilden,
S33: Auftragen von LiF auf die konjugierte Polymerschicht durch Dampfabscheidung, wodurch eine LiF-Pufferschicht gebildet wird, und
S34: Bilden einer Aluminiummetallschicht auf der LiF-Pufferschicht, um die organische elektrolumineszente Einrichtung zu produzieren.

10. Organischer Feldeffekttransistor, der mit dem konjugierten Polymer nach Anspruch 1 hergestellt ist, umfassend die folgenden aufeinanderfolgend angeordneten Strukturen: ein dotiertes Siliciumsubstrat, eine SiO₂-Isolierschicht, eine Octadecyltrichlorsilanschicht, eine organische Halbleiterschicht mit konjugiertem Polymer und Source- und Drain-Metallelektroden.

11. Verfahren zum Herstellen des organischen Feldeffekttransistors nach Anspruch 10, umfassend die folgenden Schritte:
S41: Reinigen des dotierten Siliciumsubstrats und Abscheiden einer eine Isolierwirkung aufweisenden SiO₂-Isolierschicht,
S42: Beschichten der SiO₂-Isolierschicht mit Octadecyltrichlorsilan, um eine Octadecyltrichlorsilanschicht zu bilden,
S43: Beschichten der Octadecyltrichlorsilanschicht mit dem konjugierten Polymer, um eine organische Halbleiterschicht mit konjugiertem Polymer zu bilden, und
S44: Bilden einer Source- und einer Drain-Metallelektrode auf der organischen Halbleiterschicht mit konjugiertem Polymer, um den organischen Feldeffekttransistor zu produzieren.

## Revendications

1. Polymère conjugué à base de diimide d'acide pérylènetétracarboxylique et de dibenzothiophène, ayant la formule générale suivante : 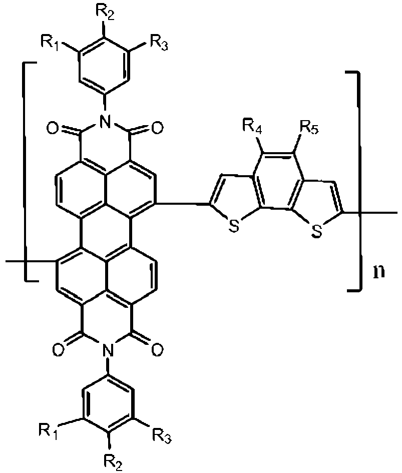 dans laquelle : n est un entier positif inférieur à 101 ; R₁, R₂ et R₃ sont un hydrogène, un alkyle en C₁-C₂₀ et un (alcoxy en C₁-C₂₀) phényle ou phényle ; et R₄ et R₅ sont un alkyle en C₁-C₂₀.

2. Procédé de préparation du polymère conjugué à base de diimide d'acide pérylènetétracarboxylique et de dibenzothiophène, comprenant les étapes suivantes :
S11 : mélange et dissolution de dibromure de diimide d'acide pérylènetétracarboxylique ou ses dérivés et d'un composé d'étain organique contenant un motif dibenzothiophène dans un solvant organique à un rapport molaire de 1:1 à 1,5:1 ; et
S12 : ajout d'un catalyseur à la solution de l'étape S11 dans un environnement anaérobie, et conduite d'une réaction de couplage de Stille à 50 °C à 120 °C pendant 24 à 72 heures pour produire une solution du polymère conjugué, avec une équation de réaction de celle-ci comme suit :

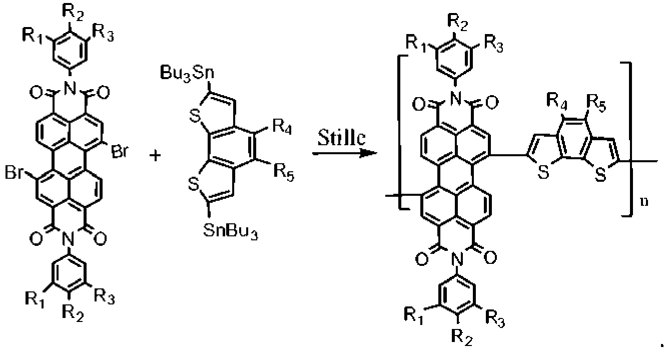

3. Procédé de préparation du polymère conjugué selon la revendication 2, dans lequel le solvant organique dans l'étape S11 est choisi dans le groupe constitué de tétrahydrofurane, le diméthylamide, le dioxane, l'éther diméthylique d'éthylène glycol, le benzène et le toluène.

4. Procédé de préparation du polymère conjugué selon la revendication 2, dans lequel le catalyseur dans l'étape S12 est ajouté en une quantité de 0,01 % à 5 % en nombre de moles des matériaux totaux ;
le catalyseur est un palladium organique ou un mélange du palladium organique et d'un ligand organophosphine ;
le palladium organique est choisi dans le groupe constitué de Pd₂(dba)₃, Pd(PPh₃)₄ et Pd(PPh₃)₂Cl₂ ;
le ligand organophosphine est P(o-Tol)₃ ; et
un rapport molaire du palladium organique au ligand organophosphine est de 1:2 à 1:20 dans le mélange du palladium organique et du ligand organophosphine.

5. Procédé de préparation du polymère conjugué selon la revendication 2, comprenant en outre un processus de purification une fois que la solution de polymère conjugué est obtenue, le processus de purification comprenant les étapes spécifiques suivantes :
S13 : ajout de la solution de polymère conjugué en gouttelettes dans du méthanol pour un traitement par précipitation, puis filtration, lavage avec du méthanol et séchage, pour obtenir un colloïde contenant le polymère conjugué ;
S14 : dissolution du colloïde contenant le polymère conjugué dans du toluène, puis ajout de la solution de toluène dans une solution aqueuse de diéthyldithiocarbamate de sodium, puis passage de la solution résultante à travers une chromatographie sur colonne d'oxyde aluminium après agitation sous chauffage à 80 °C à 100 °C pour isoler le polymère conjugué, et enfin conduite d'une décompression après élution avec du chlorobenzène pour éliminer le solvant organique ; et
S15 : répétition de l'étape S13 au moins une fois, et utilisation d'une extraction Soxhlet dans l'acétone pour extraire le polymère conjugué isolé dans l'étape S14 pour produire un polymère conjugué solide.

6. Dispositif de cellule solaire préparé avec le polymère conjugué selon la revendication 1, comprenant les structures séquentiellement agencées suivantes : un substrat, une couche conductrice, une couche de poly(3,4-éthylènedioxythiophène) / poly(styrènesulfonate), et une couche de polymère conjugué ayant un effet actif et une couche métallique d'aluminium.

7. Procédé de fabrication du dispositif de cellule solaire selon la revendication 6, comprenant les étapes suivantes :
S21 : nettoyage du substrat, puis dépôt d'une couche conductrice sur une surface de celui-ci ;
S22 : traitement de surface de la couche conductrice et revêtement de la couche conductrice avec du poly(3,4-éthylènedioxythiophène) / poly(styrènesulfonate) pour former une couche de poly(3,4-éthylènedioxythiophène) / poly(styrènesulfonate) ;
S23 : revêtement de la couche de poly(3,4-éthylènedioxythiophène) / poly(styrènesulfonate) avec le polymère conjugué pour former une couche de polymère conjugué ayant un effet actif ; et
S24 : formation d'une couche métallique d'aluminium sur la couche de polymère conjugué pour produire le dispositif de cellule solaire.

8. Dispositif électroluminescent organique préparé avec le polymère conjugué selon la revendication 1, comprenant les structures séquentiellement agencées suivantes : un substrat, une couche conductrice, une couche de polymère conjugué ayant une propriété luminescente, une couche tampon de LiF et une couche métallique d'aluminium.

9. Procédé de fabrication du dispositif électroluminescent organique selon la revendication 8, comprenant les étapes suivantes :
S31 : nettoyage du substrat, puis dépôt d'une couche conductrice sur une surface du substrat ;
S32 : traitement de surface de la couche conductrice et revêtement de la couche conductrice avec le polymère conjugué pour former une couche de polymère conjugué ayant un effet lumineux ;
S33 : revêtement de LiF sur la couche de polymère conjugué par dépôt en phase vapeur, formation d'une couche tampon de LiF ; et
S34 : formation d'une couche métallique d'aluminium sur la couche tampon de LiF pour produire le dispositif électroluminescent organique.

10. Transistor à effet de champ organique préparé avec le polymère conjugué selon la revendication 1, comprenant les structures séquentiellement agencées suivantes : un substrat de silicium dopé, une couche isolante de SiO₂, une couche d'octadécyltrichlorosilane, une couche semi-conductrice de polymère conjugué organique et des électrodes métalliques de source et de drain.

11. Procédé de fabrication du transistor à effet de champ organique selon la revendication 10, comprenant les étapes suivantes :
S41 : nettoyage du substrat de silicium dopé, et dépôt d'une couche isolante de SiO₂ ayant un effet isolant ;
S42 : revêtement de la couche isolante de SiO₂ avec de l'octadécyltrichlorosilane pour former une couche d'octadécyltrichlorosilane ;
S43 : revêtement de la couche d'octadécyltrichlorosilane avec le polymère conjugué pour former une couche semi-conductrice de polymère conjugué organique ; et
S44 : formation d'une électrode de source et d'une électrode de drain métalliques sur la couche semi-conductrice de polymère conjugué organique pour produire le transistor à effet de champ organique.
